# EUROPEAN PATENT APPLICATION

(11) **EP 4 102 658 A2**
(43) Date of publication of application: **14.12.2022**
(21) Application number: 22461571.6
(22) Date of filing: 13.06.2022
(51) Int. Cl.: H01S 5/30, H01S 5/343, H01L 21/02, H01S 5/02, H01S 5/20, H01S 5/32

(54) **EPITAXIAL LASER STRUCTURE AND METHOD OF FABRICATION OF EPITAXIAL LASER STRUCTURE**

(30) Priority: 13.06.2021 PL 43813621
(71) Applicant: Instytut Wysokich Cisnien Polskiej Akademii Nauk, 01-142 Warszawa (PL)
(72) Inventor: LACHOWSKI, Artur, 03-138 Warszawa (PL); GRZANKA, Ewa, 05-803 Pruszków (PL); GRZANKA, Szymon, 05-803 Pruszków (PL); CZEMECKI, Robert, 42-284 Kalina (PL); SMALC-KOZIOROWSKA, Julita, 02-792 Warszawa (PL); GRABOWSKI, Miko aj, 00-407 Warszawa (PL); HRYTSAK, Roman, 78-023 Daleva (UA); LESZCZY SKI, Micha, 05-515 Mysiad o (PL)
(74) Representative: Adamczyk, Piotr

(57) **Abstract**

The laser structure contains a substrate (1) and the following placed successively on said substrate (1): a buffer layer (2), a lower n-type cladding layer (3), a lower waveguide layer (4), an optically active region with at least one quantum well layer (6) and a barrier (7) adjacent to said layer above said layer, an upper waveguide layer (8), an electron blocking layer (9), an upper p-type cladding layer (10), and a subcontact layer (11), made epitaxially of III group nitrides compounds. A separation layer (5) with the thickness exceeding 2 nm, made of silicon-doped gallium nitride with the doping range from 10¹⁸ to 10²⁰ cm⁻³, is placed between the lower waveguide layer (4) and the quantum well (6) that is adjacent thereto. The method consists in the application of the aforementioned separation layer (5) following the fabrication of the lower waveguide layer (4) and the application of the first quantum well layer (6) only to the separation layer in the epitaxial process of fabrication of the known laser structure.

## Description

The present invention relates to an epitaxial laser structure fabricated on a substrate of Al₂O₃ or GaN, wherein the n-type and p-type conductivity layers, the waveguides and the active region, which is composed of quantum wells and barriers, are made of group III nitrides compounds, and to a method of fabrication of such structures.

Epitaxial technologies make it possible to fabricate complex laser structures based on gallium nitride (GaN). The possibility to apply active regions in the form of quantum wells, the thickness and chemical composition of which can be in a broad range, makes it possible to make laser diodes emitting light from ultraviolet to red. At the same time, such diodes are characterised by a relatively low sensitivity to the presence of crystal lattice defects, which makes it possible to achieve a high efficiency with a low energy consumption. Owing to the above, they are widely applied as light sources in the high-technology industry, medicine and modern test apparatus. One of the problems related to the epitaxial growth of nitride laser structures designed to emit blue and green light was thermal instability of InGaN quantum wells. During the epitaxial growth of a complete laser structure, the active region must be overgrown with p-type conductivity layers. The crucial parameter for obtaining high-quality p-type layers is the temperature of their growth, which should be higher than 950°C. However, the growth of p-type layers at such temperatures leads to thermal instability of quantum wells. In such a case extensive structural defects are formed within the wells, which entails a drastic decrease in the efficiency of an instrument made of such a structure. In order to preserve a high structural quality of quantum wells, which is a priority from the point of view of laser emission, it is necessary to grow the p-type layers at lower temperatures. However, p-type layers obtained at such lower temperatures have a worse conductance, which impairs effective supply of current carriers to the active region. As a result, laser diodes with high-quality quantum wells are obtained, but the efficiency of these devices is limited by the worse quality of the p-type layers. The thermal instability of InGaN quantum wells is related to their structural heterogeneity, that is, to fluctuations of the indium composition. The known solutions of this problem are based to a large extent on an optimisation of the growth process of the wells themselves. Appl. Phys. Lett. 103, 152109 (2015) describes the heterogeneity of indium layout as a result of formation of indium clusters on the well surface during the epitaxial growth. In order to avoid this phenomenon, it was proposed to apply a thin layer of low-temperature gallium nitride directly to the well surface, which layer aimed to prevent indium atom desorption from the layer surface.

J. Appl. Phys., 117, 055709 (2015) and Appl. Phys. Lett. 85, 4379 (2004) disclose interruption of the epitaxial growth process directly following the quantum well growth in order to enable desorption of excess indium atoms from the quantum well surface, the presence of which atoms could also have led to the thermal instability of the well. Because, as mentioned above, the primary cause of the well decomposition is a high temperature of the p-type layer growth, a decrease in said temperature to a level guaranteeing minimisation of this phenomenon is disclosed in all the aforementioned publications. Such a solution is described also in US2011/0104843A1, which proposes that the thermal degradation of the well can be avoided by the p-type layer growth by the HVPE method at the temperature of up to 900°C.

J. Alloys Compd., p. 153571, Dec. 2019 (2020) discloses an improvement of the quantum well stability through optimisation of growth of the GaN quantum barriers as a result of a decrease in the temperature of barrier growth combined with 1% indium addition. This reduces the quantity of V-pit defects, which, in turn, should directly improve the thermal stability of the wells, because such defects can initiate the thermal decomposition of quantum wells, that is, their degradation.

The use of a different type of substrate for the epitaxial growth of the structure of a light emitting diode (LED) is described in Opt. Mater. 85 (Amst), 14-17 (2018). The GaN layers on the Al₂O₃ substrate used for this purpose as a standard are characterised by a high density of threading dislocations, which has a negative impact on the thermal stability of quantum wells. The replacement of the Al₂O₃ substrate with a bulk gallium nitride substrate, in which the density of threading dislocations is typically lower, enabled a reduction of quantum well degradation, thereby exerting a positive impact on the optical parameters of the light emitters. Nevertheless, implementation of such a solution involves increased costs of fabrication of LEDs due to the considerably higher cost of the bulk gallium nitride substrate compared to the Al₂O₃ substrate.

Opt. Express, 27, 25943 (2019) describes a concept of reduction of gallium vacancy concentration in the lower waveguide layer, that is, in the layer located directly under the InGaN/GaN active region. For this purpose, a GaN/InGaN superlattice grown at the temperature of 790°C was used. The low growth temperature combined with the presence of indium should reduce the quantity of gallium vacancies compared to a layer of silicon-doped gallium nitride grown at the temperature of 1050°C, which is applied as a standard. Nevertheless, the impact of this treatment on the thermal stability of quantum wells remains unclear, because the authors of said publication simultaneously used a low-temperature p-type layer applied at the temperature of 920°C, which could have been of crucial significance for the stability of quantum wells.

The object of the invention is to obtain an epitaxial layer laser structure with quantum wells exhibiting thermal stability during the growth of p-type conductivity layers thereon at the temperature of at least 950°C.

This object is achieved by an epitaxial laser structure containing an aluminium oxide or gallium nitride substrate and the following placed successively on said substrate: a buffer layer, a lower n-type cladding layer, a lower waveguide layer, an optically active region with at least one quantum well layer and a barrier adjacent to said layer above said layer, an upper waveguide layer, an electron blocking layer, an upper p-type cladding layer, and a subcontact layer. All these layers are made epitaxially of III group nitrides compounds. The invention consists in placement of a separation layer with the thickness exceeding 2 nm, made of silicon-doped gallium nitride with the doping range from 10¹⁸ to 10²⁰ cm⁻³, within the optically active region directly under the quantum well that is closest to the lower waveguide layer.

In one of the variants of the structure according to the invention, the silicon doping level of the separation layer is at least twice as high as the silicon doping level of the optically active region's barriers.

In another variant of the structure according to the invention, the optically active region contains five quantum well layers and five barriers.

The method according to the invention consists in epitaxial growth of the following successively on an aluminium oxide or gallium nitride substrate: a buffer layer, a lower n-type cladding layer, a lower waveguide layer, an optically active region with at least one quantum well layer and a barrier adjacent to said layer above said layer, an upper waveguide layer, an electron blocking layer, an upper p-type cladding layer, and a subcontact layer, which are made of III group nitrides compounds. The method according to the invention is characterised in that a separation layer with the thickness exceeding 2 nm, made of silicon-doped gallium nitride with the doping range from 10¹⁸ to 10²⁰ cm⁻³, is applied epitaxially to the fabricated lower waveguide layer.

In one of the variants of the method according to the invention, the epitaxial growth of the upper p-type cladding layer takes place at the temperature of at least 950 °C.

In another variant of the method according to the invention, an optically active region composed of five successive quantum well layers covered with barriers is applied to the separation layer.

The invention enables obtaining efficient laser diodes emitting blue and green light with a slight and cheap modification of the known process of laser structure growth and without the need to modify the technologies of fabrication of finished laser diodes with the use of such structures. The use of a separation layer according to the invention enables growing the p-type layer in the conditions which are optimal for said layer, that is, at the temperature above 950°C, without the risk of degradation of the quantum wells already fabricated on the substrate. The invention enables safe fabrication of laser structures containing up to five stable quantum wells, which makes it possible to control the laser parameters.

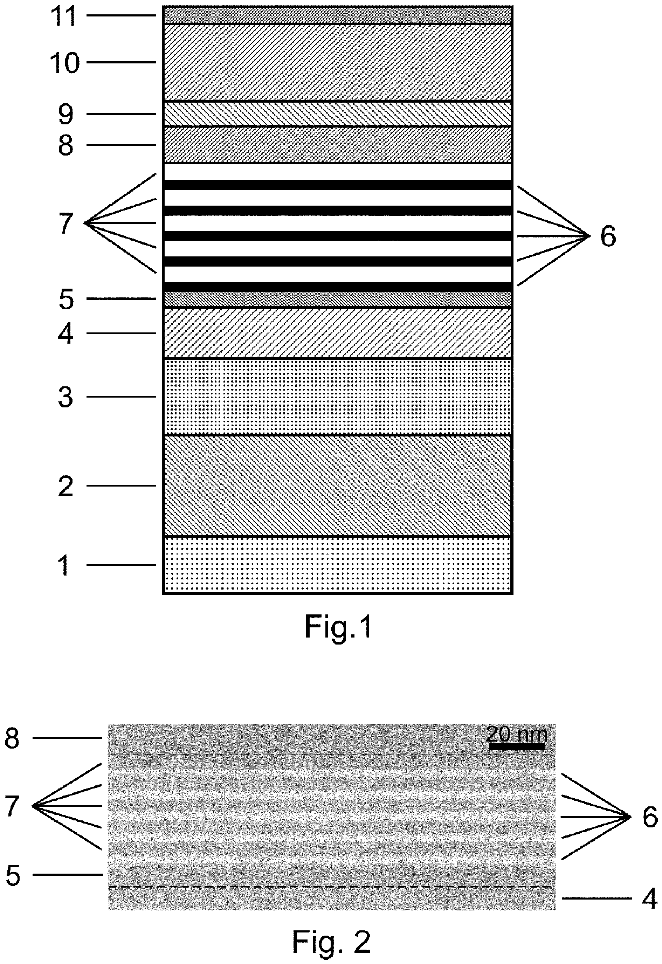

The invention is shown in the exemplary embodiment in the drawing, Fig.1 of which presents schematically the composition of an exemplary layer laser structure described below, while Fig.2 of which presents a TEM (transmission electron microscope) image of the quantum well from the embodiment of the invention described below.

Two exemplary embodiments of the laser structure according to the invention are described in detail below. The known laser structure has a substrate 1, to which the following are applied successively: buffer layer 2, lower n-type cladding layer 3, lower waveguide layer 4, optically active region, upper waveguide layer 8, electron blocking layer 9, upper p-type cladding layer 10 and subcontact layer 11. The optically active region is composed of at least one quantum well layer 6 and a barrier 7 covering it on the above. All layers of the laser structure are fabricated in the known process of epitaxial growth of III group nitrides or their derivatives on an aluminium oxide (Al₂O₃) or gallium nitride substrate. The laser structures according to the invention have a separation layer 5 placed between the lower waveguide layer 4 and the first, counted from the substrate 1, quantum well layer 6. The separation layer 5 is made of silicon-doped gallium nitride with the doping range from 10¹⁸ to 10²⁰ cm⁻³.

### Example 1

### Laser structure on a gallium nitride substrate, emitting blue light

The known MOVPE (Metalorganic Vapour Phase Epitaxy) epitaxial growth process was used for fabricating said laser structure. A bulk GaN crystal, smoothened to achieve the smoothness of atomic steps, was used as substrate 1. Thus prepared substrate 1 was placed in the load-lock of the MOVPE reactor, from which the gas present there was pumped out at least three times with the use of a rotary pump and which was filled with pure nitrogen (5N). Subsequently the substrate 1 was transferred to the glove-box of the aforementioned reactor, with controlled purity (dew point at least -70°C). During the proper epitaxial process, the surface of the substrate 1 was purified by soaking in the atmosphere of ammonia (NH3) and hydrogen (H2), after which a buffer layer 2 with the thickness of circa 2 µm, made of silicon-doped GaN:Si with the doping level of 2 x 10¹⁸ cm⁻³ with the use of trimethylgallium (TMGa) and silane (SiH₄), was applied to said surface. Subsequently, an n-type lower cladding layer 3 with the thickness of 800 nm, made of Al_{0.08}GaN:Si with the doping level of 3 × 10¹⁸ cm⁻³ with the use of TMGa and trimethylaluminium (TMAI), was applied. In the next step, a lower waveguide layer 4 with the thickness of 100 nm, made of In_{0.04}Ga_{0.96}N:Si with the doping level of 3 × 10¹⁸ cm⁻³ with the use of NH3, triethylgallium (TEGa), trimethylindium (TMIn) and SiH₄, was applied. The subsequently applied optically active region contained a separation layer 5 with the thickness of 7 nm, made of GaN:Si with the doping level of 10¹⁹ cm⁻³, with the use of NH3, TEGa and SiH₄, five quantum well layers 6 with the thickness of circa 3 nm, made of In_{0.16}Ga_{0.84}N with the use of NH3, TEGa and TMIn. Each quantum well 6 was covered with a barrier 7 with the thickness of 7 nm, made of GaN with the use of NH₃ and TEGa. Above the top layer of the barrier 7, the upper waveguide layer 8 with the thickness of 50 nm, made of In_{0.04}Ga_{0.96}N with the use of NH3, TEGa and TMIn, was applied. In the next stage, an electron blocking layer 9 with the thickness of 20 nm, made of magnesium-doped Al_{0.15}Ga_{0.85}N:Mg with the doping level of 5 × 10¹⁹ cm-³ with the use of NH3, TMAI, TMGa and bis(cyclopentadienyl)magnesium (Cp₂Mg), was applied. The upper cladding layer 10 with the thickness of 400 nm, made of Al_{0.03}Ga_{0.97}N:Mg with the use of NH₃, TMAI, TMGa and Cp2Mg, with the magnesium doping level of 5 × 10¹⁹ cm⁻³, was applied as the next layer, at the temperature of 950°C. The last stage of the epitaxial growth was the application of a subcontact layer 11 with the thickness of 15 nm, made of magnesium-doped GaN:Mg with the doping level of 10²⁰ cm⁻³ with the use of NH3, TMGa and Cp2Mg. The obtained laser structure was characterised by the quantity of threading dislocations of 10⁵ - 10⁷ cm⁻². This structure was used according to a known method for making a laser diode emitting blue light, that is, light with the wavelength between 440 nm and 495 nm. It turned out that said diode had a circa 10 to 20% higher efficiency relative to traditional diodes and simultaneously required a circa 10% lower current density to initiate the laser action.

### Example 2

### Laser structure on an aluminium oxide substrate, emitting blue light

For the epitaxial growth of the laser structure, the substrate 1 was prepared from the bulk aluminium oxide (Al₂O₃) crystal covered with a gallium nitride layer with the thickness of circa 3 µm in a known epitaxial process. Thus prepared substrate 1 was placed in the load-lock of the same MOVPE reactor as the one in the first embodiment and the same epitaxial growth of the layer laser structure was performed in said reactor as in the first example. The obtained laser structure was characterised by the quantum wells with the structural quality comparable to the quality of the quantum wells grown on the gallium nitride substrate, that is, in the first example, but due to the used substrate the whole structure had a higher quantity of threading dislocations, that is, 10⁸ cm⁻². Similarly to the first example, the laser diode made of said structure was characterised by the higher efficiency and lower required current density provided in the first example.

### Example 3

### Laser structure on a gallium nitride substrate, emitting green light

Similarly to the previous examples, the MOVPE process performed in the same reactor was used for fabricating said laser structure. The preparation of the substrate 1 of the bulk GaN crystal and the successive application of the buffer layer 2, lower cladding layer 3, lower waveguide layer 4 and separation layer 5 thereto were performed according to the same method as in the first example. Subsequently, an optically active region containing a separation layer 5 with the thickness of 7 nm, made of GaN:Si with the doping level of 10¹⁹ cm⁻³ with the use of NH3, TEGa and SiH₄, five quantum well layers 6 with the thickness of 3 nm, made of In_{0.20}Ga_{0.80}N with the use of NH3, TEGa and TMIn, was applied to the lower waveguide layer 4. Each quantum well 6 was covered with a barrier 7 with the thickness of 7 nm, made of GaN with the use of NH₃ and TEGa, that is, the same as in the first example. An upper waveguide layer 8, an electron blocking layer 9, an upper cladding layer 10 and a subcontact layer 11 were applied successively above the top layer of the barrier 7 according to the same method as the corresponding layers 8, 9, 10 and 11 in the first example. The obtained laser structure was characterised by the quantity of threading dislocations of 10⁵ - 10⁷ cm⁻². The laser diode made of said structure emitted light with the wavelength within the range between 500 and 540 nm and had a 10 to 15% higher efficiency relative to known diodes of this type and at the same time had a circa 10% lower current density required for initiating the laser action.

### Example 4

### Laser structure on the aluminium oxide substrate, emitting green light

The growth process was performed according to the same method as in the second example, but the quantum well layers 6 were made of In_{0.20}Ga_{0.80}N according to the same method as in the third example. The obtained laser structure was characterised by quantum wells with the structural quality comparable to the quality of quantum wells grown on a gallium nitride substrate, but due to the used substrate the whole structure had a higher quantity of threading dislocations than in the third embodiment, that is, 10⁸ cm⁻². The laser diode made of said structure had a higher efficiency, similarly to the diode from the third example.

## Claims

1. An epitaxial laser structure containing an aluminium oxide or gallium nitride substrate and the following placed successively on said substrate: a buffer layer, a lower n-type cladding layer, a lower waveguide layer, an optically active region with at least one quantum well layer and a barrier adjacent to said layer above said layer, an upper waveguide layer, an electron blocking layer, an upper p-type cladding layer, and a subcontact layer, made epitaxially of III group nitrides compounds, **characterised in that** a separation layer (5) with the thickness exceeding 2 nm, made of silicon-doped gallium nitride with the doping range from 10¹⁸ to 10²⁰ cm⁻³, is placed within the optically active region (5, 6, 7) directly under the quantum well (6) that is closest to the lower waveguide layer (4).

2. The laser structure according to claim 1, **characterised in that** the silicon doping level of the separation layer (5) is at least twice as high as the silicon doping level of the optically active region's barriers (7).

3. The laser structure according to claim 1 or 2, **characterised in that** the optically active region (5, 6, 7) contains five quantum well layers (6) and five barriers (7).

4. A method of fabrication of an epitaxial laser structure consisting in epitaxial growth of the following successively on an aluminium oxide or gallium nitride substrate: a buffer layer, a lower n-type cladding layer, a lower waveguide layer, an optically active region with at least one quantum well layer and a barrier adjacent to said layer above said layer, an upper waveguide layer, an electron blocking layer, an upper p-type cladding layer, and a subcontact layer, which are made of III group nitrides compounds, **characterised in that** a separation layer (5) with the thickness exceeding 2 nm, made of silicon-doped gallium nitride with the doping range from 10¹⁸ to 10²⁰ cm⁻³, is applied epitaxially to the fabricated lower waveguide layer (4).

5. The method according to claim 4, **characterised in that** the epitaxial growth of the upper p-type cladding layer (10) takes place at the temperature of at least 950°C.

6. The method according to claim 4 or 5, **characterised in that** five successive quantum well layers (6) covered with barriers (7) are applied in the optically active region (5, 6, 7).
